# EUROPEAN PATENT APPLICATION

(11) **EP 4 525 567 A1**
(43) Date of publication of application: **19.03.2025**
(21) Application number: 23843426.0
(22) Date of filing: 21.07.2023
(51) Int. Cl.: H05K 5/02, H05K 5/00, H04M 1/02

(54) **BUFFER FRAME MODULE AND ELECTRONIC DEVICE COMPRISING SAME**

(30) Priority: 22.07.2022 KR 20220090795; 19.08.2022 KR 20220103763
(71) Applicant: Samsung Electronics Co., Ltd., Suwon-si, Gyeonggi-do 16677 (KR)
(72) Inventor: BAEK, Moohyun, Suwon-si Gyeonggi-do 16677 (KR); NOH, Daeyoung, Suwon-si Gyeonggi-do 16677 (KR)
(74) Representative: Gulde & Partner
(86) International application number: PCT/KR2023/010552
(87) International publication number: WO 2024/019580

(57) **Abstract**

According to an embodiment, an electronic device includes a first surface plate, a second surface plate located opposite the first surface plate, and a frame module surrounding at least a portion of a space formed between the first surface plate and the second surface plate, wherein the frame module comprises a bracket including a bracket end surface, an external cover including a first cover surface and a second cover surface opposite the first cover surface and surrounding the bracket, and a buffer groove including a space formed by arranging the bracket end surface of the bracket and at least a portion of the second cover surface of the external cover to face each other, and the buffer groove may be filled with a buffer member.

## Description

### BACKGROUND

### 1. Field

The disclosure relates to a frame module and an electronic device including the frame module.

### 2. Description of Related Art

An electronic device may include a frame module. The frame module may protect electronic/mechanical components included in the electronic device. The frame module may enhance the appearance of the electronic device. The above description is provided by way of background, and is not necessarily art publicly known.

### SUMMARY

According to an example embodiment, an electronic device includes: a first surface plate, a second surface plate positioned on a side opposite to the first surface plate, and a frame module including a frame enclosing at least a portion of a space formed between the first surface plate and the second surface plate. The frame module may include a bracket including a bracket having an end surface, an outer cover including a cover and having a first cover surface and a second cover surface opposite to the first cover surface, and enclosing the bracket, and a buffer groove including a space between the bracket end surface of the bracket and at least a portion of the second cover surface of the outer cover which face each other, and the buffer groove may be filled with a buffer member including a buffer material.

According to an example embodiment, a frame module including a frame and surrounding an outer edge of an electronic device includes: a bracket including a bracket having an end surface, an outer cover including a cover and having a first cover surface and a second cover surface opposite to the first cover surface, and enclosing the bracket, and a buffer groove including a space between the bracket end surface of the bracket and at least a portion of the second cover surface of the outer cover which face each other. A buffer member comprising a buffer material having a shock-absorbing effect is disposed in the buffer groove, and the bracket and the outer cover may be coupled by the buffer member.

According to an example embodiment, an electronic device includes: a first surface plate, a second surface plate positioned on a side opposite to the first surface plate, and a frame module including a frame and enclosing at least a portion of a space formed between the first surface plate and the second surface plate. The frame module may include a bracket including a bracket having an end surface, an outer cover including a cover and having a first cover surface and a second cover surface opposite to the first cover surface, and enclosing the bracket, and a buffer groove formed between the bracket end surface of the bracket and at least a portion of the second cover surface of the outer cover which face each other, the bracket may include a plurality of bracket recesses formed in a direction opposite to a direction from the bracket end surface toward the second cover surface, at least one bracket rib formed between the bracket recesses, and at least one bracket jaw formed at a point where the bracket recesses end, the outer cover may include a plurality of cover recesses formed in a direction opposite to a direction from the second cover surface toward the bracket end surface, and the buffer groove may be formed in a space between the bracket recess and the cover recess.

### BRIEF DESCRIPTION OF THE DRAWINGS

FIG. 1 is a block diagram illustrating an example electronic device in a network environment according to various embodiments;
FIG. 2A is a front perspective view of an electronic device according to various embodiments;
FIG. 2B is a rear perspective view of an electronic device according to various embodiments;
FIG. 2C is an exploded perspective view of an electronic device according to various embodiments;
FIG. 3A is an exploded perspective view of an electronic device according to various embodiments;
FIG. 3B is a cross-sectional view of a frame module according to various embodiments;
FIG. 3C is an enlarged view of a region A of FIG. 3B according to various embodiments;
FIG. 3D is an enlarged view of the region A of FIG. 3B according to various embodiments;
FIG. 4A is an enlarged view of a portion of an electronic device according to various embodiments;
FIG. 4B is a front perspective view of a frame module according to various embodiments;
FIG. 4C is a cross-sectional view of the frame module of FIG. 4A taken along a line A-A according to various embodiments;
FIG. 4D is a cross-sectional view of the frame module of FIG. 4A taken along a line B-B according to various embodiments;
FIG. 5 is a partial perspective view of an outer cover according to various embodiments;
FIG. 6A is a cross-sectional view of a frame module according to various embodiments; and
FIG. 6B is a perspective view of a bracket according to various embodiments.

### DETAILED DESCRIPTION

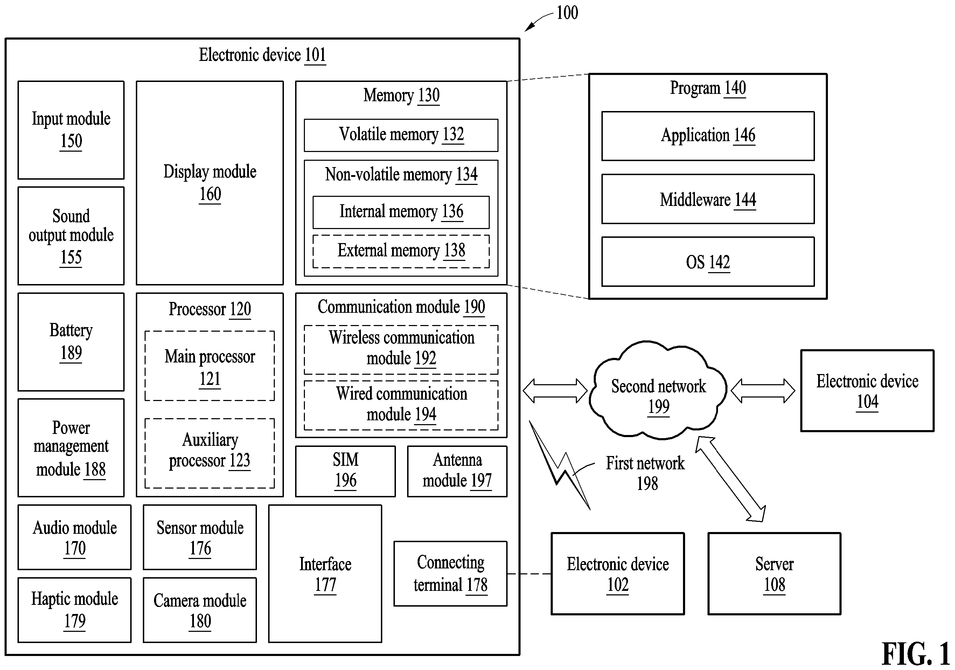

Referring to FIG. 1, an electronic device 101 in a network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one (e.g., the connecting terminal 178) of the above components may be omitted from the electronic device 101, or one or more other components may be added in the electronic device 101. In various examples, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An artificial intelligence model may be generated by machine learning. Such learning may be performed by, for example, the electronic device 101 in which artificial intelligence is performed, or performed via a separate server (e.g., the server 108). A learning algorithm may include, but is not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and control circuitry to control a corresponding one of the display, the hologram device, or the projector. According to an embodiment, the display module 160 may include a touch sensor adapted to sense a touch, or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local region network (LAN) communication module, or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide region network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mm Wave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of the same type as or a different type from the electronic device 101. According to an embodiment, all or some of operations to be executed by the electronic device 101 may be executed at one or more external electronic devices (e.g., the external electronic devices 102 and 104, and the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic device may include, for example, a portable communication device (e.g., a smartphone), a computer device, a portable multimedia device, a portable medical device, a camera, a wearable device, a home appliance device, or the like. According to an embodiment of the disclosure, the electronic device is not limited to those described above.

It should be appreciated that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," may include any one of the items listed together in the corresponding one of the phrases, or all possible combinations thereof. Terms such as "1st," and "2nd," or "first" or "second" may simply be used to distinguish the component from other components in question, and do not limit the components in other aspects (e.g., importance or order). It is to be understood that if an element (e.g., a first element) is referred to, with or without the term "operatively" or "communicatively," as "coupled with," "coupled to," "connected with," or "connected to" another element (e.g., a second element), the element may be coupled with the other element directly (e.g., by wire), wirelessly, or via a third element.

As used in connection with an embodiment of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStoreTM), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

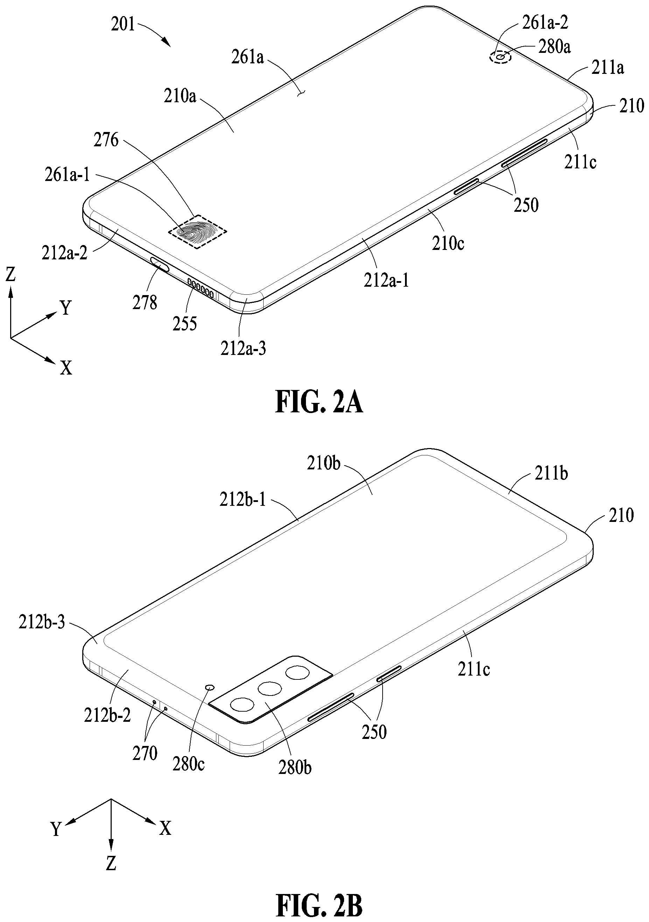

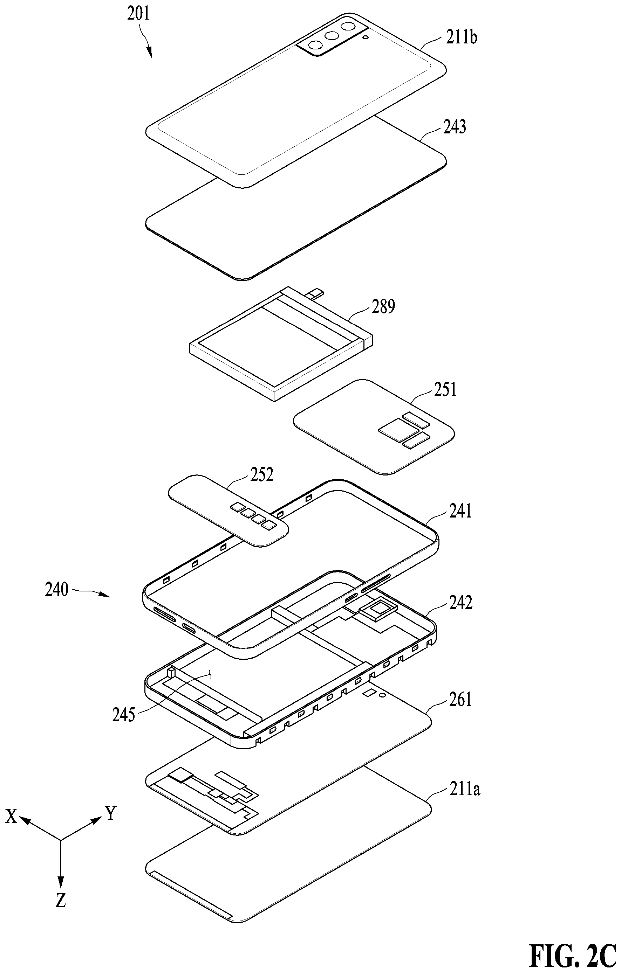

FIG. 2A is a front perspective view of an electronic device according to various embodiments. FIG. 2B is a rear perspective view of an electronic device according to various embodiments. FIG. 2C is an exploded perspective view of an electronic device according to various embodiments.

Referring to FIGS. 2A, 2B and 2C, an electronic device 201 (e.g., the electronic device 101 of FIG. 1) may include a housing 210 including a first surface 210a (e.g., a front surface), a second surface 210b (e.g., a rear surface), and a third surface 210c (e.g., a side surface) enclosing a space between the first surface 210a and the second surface 210b.

In an embodiment, the first surface 210a may be formed by a display 211a (e.g., the display module 160 of FIG. 1) of which at least a portion is substantially transparent. For example, the display 211a may include a polymer plate or a glass plate including at least one coating layer.

In an embodiment, the second surface 210b may be formed by a rear cover 211b that is substantially opaque. For example, the rear cover 211b may be formed of coated or tinted glass, ceramic, polymer, metal (e.g., aluminum, stainless steel (STS), or magnesium), or a combination thereof.

In an embodiment, the third surface 210c may be formed by a frame 211c that is coupled to the display 211a and the rear cover 211b and that includes a metal and/or a polymer.

In an embodiment, the rear cover 211b and the frame 211c may be integrally and seamlessly formed. In an embodiment, the rear cover 211b and the frame 211c may be formed of substantially the same material (e.g., aluminum).

In an embodiment, the display 211a may include a plurality of first periphery areas 212a-1. The plurality of first periphery areas 212a-1 may face the rear cover 211b from at least a partial region of the first surface 210a. The plurality of first periphery areas 212a-1 may be in contact with the rear cover 211b. The plurality of first periphery areas 212a-1 may extend in one direction (e.g., +/-Y direction). The display 211a may include a plurality of second periphery areas 212a-2. The plurality of second periphery areas 212a-2 may face the rear cover 211b from at least a partial region of the first surface 210a. The plurality of second periphery areas 212a-2 may be in contact with the rear cover 211b. The plurality of second periphery areas 212a-2 may extend in a direction (e.g., +/-X direction) different from an extending direction (e.g., the +/-Y direction) of the plurality of first periphery areas 212a-1. The display 211a may include a plurality of third periphery areas 212a-3. The plurality of third periphery areas 212a-3 may face the rear cover 211b from at least a partial region of the first surface 210a. The plurality of third periphery areas 212a-3 may be in contact with the rear cover 211b. The plurality of third periphery areas 212a-3 may be disposed between the plurality of first periphery areas 212a-1 and the plurality of second periphery areas 212a-2.

In an embodiment, the rear cover 211b may include a plurality of fourth periphery areas 212b-1. The plurality of fourth periphery areas 212b-1 may face the display 211a from at least a partial region of the second surface 210b. The plurality of fourth periphery areas 212b-1 may be in contact with the display 211a. The plurality of fourth periphery areas 212b-1 may extend in one direction (e.g., the +/-Y direction). The rear cover 211b may include a plurality of fifth periphery areas 212b-2. The plurality of fifth periphery areas 212b-2 may face the display 211a from at least a partial region of the second surface 210b. The plurality of fifth periphery areas 212b-2 may be in contact with the display 211a. The plurality of fifth periphery areas 212b-2 may extend in a direction (e.g., the +/-X direction) different from an extending direction (e.g., the +/-Y direction) of the plurality of fourth periphery areas 212b-1. The rear cover 211b may include a plurality of sixth periphery areas 212b-3. The plurality of sixth periphery areas 212b-3 may face the display 211a from at least a partial region of the second surface 210b. The plurality of sixth periphery areas 212b-3 may be in contact with the display 211a. The plurality of sixth periphery areas 212b-3 may be disposed between the plurality of fourth periphery areas 212b-1 and the plurality of fifth periphery areas 212b-2.

In an embodiment, the display 211a may include a touch sensing circuit, a pressure sensor for measuring an intensity (pressure) of a touch, and/or a digitizer for detecting a magnetic-type stylus pen.

In an embodiment, the display 211a may include a screen display area 261a that is visually exposed (e.g., visible) to display content using pixels. In an embodiment, the screen display area 261a may include a sensing area 261a-1. The sensing area 261a-1 may overlap at least a partial area of the screen display area 261a. The sensing area 261a-1 may allow transmission of an input signal related to a sensor module 276 (e.g., the sensor module 176 of FIG. 1). The sensing area 261a-1 may display content, similarly to the screen display area 261a that does not overlap the sensing area 261a-1. For example, the sensing area 261a-1 may display the content while the sensor module 276 is not operating. At least a portion of a camera area 261a-2 may overlap the screen display area 261a. In an embodiment, the screen display area 261a may include the camera area 261a-2. The camera area 261a-2 may allow transmission of an optical signal related to a first camera module 280a (e.g., the camera module 180 of FIG. 1). At least a portion of the camera area 261a-2, that overlaps the screen display area 261a, may display content, similarly to the screen display area 261a that does not overlap the camera area 261a-2. For example, the camera area 261a-2 may display the content while the first camera module 280a is not operating.

In an embodiment, the electronic device 201 may include an audio module 270 (e.g., the audio module 170 of FIG. 1). In an embodiment, the audio module 270 may be positioned on the third surface 210c. In an embodiment, the audio module 270 may obtain sound through at least one hole.

In an embodiment, the electronic device 201 may include the sensor module 276. In an embodiment, the sensor module 276 may be positioned on the first surface 210a. The sensor module 276 may form the sensing area 261a-1 in at least a portion of the screen display area 261a. The sensor module 276 may receive an input signal transmitted through the sensing area 261a-1 and generate an electrical signal based on the received input signal. In an example, the input signal may have a designated physical quantity (e.g., heat, light, temperature, sound, pressure, or ultrasound). In an example, the input signal may include a signal related to biometric information (e.g., a fingerprint) of a user.

In an embodiment, the electronic device 201 may include the first camera module 280a (e.g., the camera module 180 of FIG. 1). In an embodiment, the first camera module 280a may be positioned on the first surface 210a. In an embodiment, at least a portion of the first camera module 280a may be positioned under the display 211a. In an embodiment, the first camera module 280a may receive an optical signal transmitted through the camera area 261a-2.

In an embodiment, the electronic device 201 may include a second camera module 280b (e.g., the camera module 180 of FIG. 1). The second camera module 280b may be positioned on the second surface 210b. In an embodiment, the second camera module 280b may include a plurality of camera modules (e.g., a dual camera, a triple camera, or a quad camera).

In an embodiment, the electronic device 201 may include a flash 280c. The flash 280c may be positioned on the second surface 210b. In an embodiment, the flash 280c may include a light-emitting diode or a xenon lamp.

In an embodiment, the electronic device 201 may include a sound output module 255 (e.g., the sound output module 155 of FIG. 1). In an embodiment, the sound output module 255 may be positioned on the third surface 210c. In an embodiment, the sound output module 255 may include one or more holes.

In an embodiment, the electronic device 201 may include an input module 250 (e.g., the input module 150 of FIG. 1). In an embodiment, the input module 250 may be positioned on the third surface 210c. In an embodiment, the input module 250 may include at least one key input device.

In an embodiment, the electronic device 201 may include a connecting terminal 278 (e.g., the connecting terminal 178 of FIG. 1). In an embodiment, the connecting terminal 278 may be positioned on the third surface 210c. For example, when the electronic device 201 is viewed in one direction (e.g., the +Y direction), the connecting terminal 278 may be positioned substantially in a central portion of the third surface 210c, and the sound output module 255 may be positioned on one side (e.g., a right side) with respect to the connecting terminal 278.

In an embodiment, the electronic device 201 may include a support body 240, a first circuit board 251, a second circuit board 252, and a battery 289 (e.g., the battery 189 of FIG. 1). At least a portion of the support body 240 may form the housing 210 together with the display 211a and the rear cover 211b.

In an embodiment, the support body 240 may include a first frame structure 241, a second frame structure 243, and a plate structure 242. The first frame structure 241 may surround the periphery of the plate structure 242. The first frame structure 241 may connect the periphery of the display 211a and the periphery of the rear cover 211b. The first frame structure 241 may enclose a space between the display 211a and the rear cover 211b. At least a portion of the first frame structure 241 may form the third surface 210c of the electronic device 201. The second frame structure 243 may be positioned between the first frame structure 241 and the rear cover 211b. The first frame structure 241 and the second frame structure 243 may at least partially form the frame 211c. The display 211a may be positioned on one surface (e.g., a bottom surface or in a +Z-axis direction) of the plate structure 242. The first circuit board 251 and the second circuit board 252 may be positioned on the other surface (e.g., a top surface or in a -Z axis direction) of the plate structure 242. In an embodiment, the plate structure 242 may include an opening 245. The opening 245 may pass through both sides of the plate structure 242. The opening 245 may accommodate the battery 289.

Meanwhile, one or more embodiment(s) provided herein may also be applied to electronic devices of various shapes/forms (e.g., a foldable electronic device, a slidable electronic device, a digital camera, a digital video camera, a tablet PC, a laptop computer, and other electronic devices), in addition to the electronic device shown in FIGS. 2A, 2B and 2C.

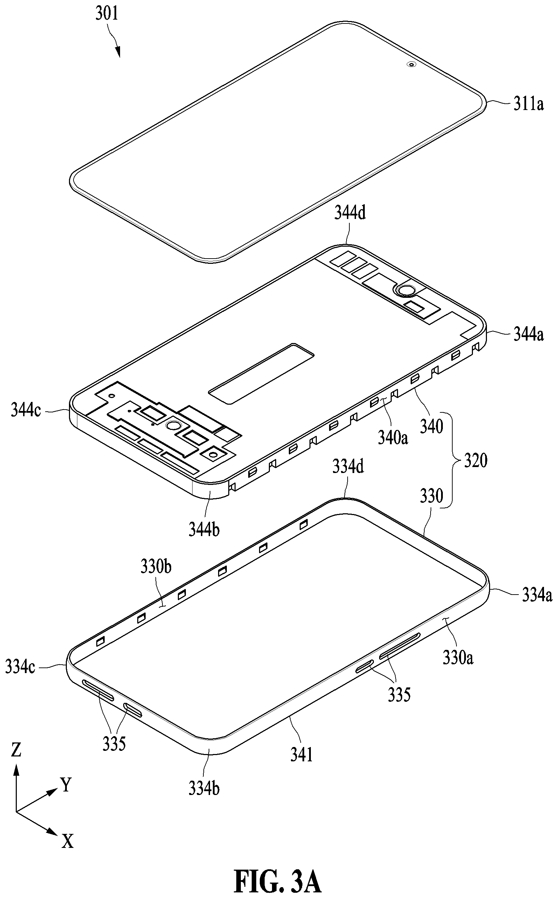

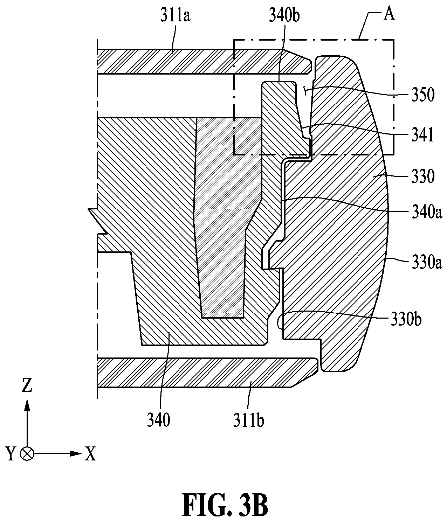

FIG. 3A is an exploded perspective view of an electronic device 301 according to various embodiments. FIG. 3B is a partial cross-sectional view of a frame module 320 (e.g., the support body 240 of FIG. 2C) according to various embodiments.

In an embodiment, the electronic device 301, the frame module 320, or a combination thereof may be coupled to at least one configuration or feature of the above-described embodiments, unless it is technically impossible.

Referring to FIGS. 3A and 3B, the electronic device 301 (e.g., the electronic device 101 of FIG. 1 and/or the electronic device 201 of FIGS. 2A to 2C) may include a display 311a (e.g., the display 211a of FIGS. 2A and 2C). The electronic device 301 may include a rear cover 311b (e.g., the rear cover 211b) positioned on a side opposite to the display 311a. The electronic device 301 may include a frame module 320 enclosing at least a portion of a space formed between the display 311a and the rear cover 311b.

In an embodiment, the frame module 320 may include an outer cover 330 (e.g., the first frame structure 241 of FIG. 2C). The outer cover 330 may include a first cover surface 330a (e.g., an outer surface of the outer cover). The outer cover 330 may include a second cover surface 330b (e.g., an inner surface of the outer cover) formed on a side opposite to the first cover surface 330a. The outer cover 330 may at least partially surround an outer surface of a bracket 340, for example, a bracket end surface 340a. The outer cover 330 may include cover covers 334a, 334b, 334c, and 334d (e.g., the third periphery area 212a-3 and/or the sixth periphery area 212b-3 of FIG. 2A and/or FIG. 2B). The cover corners 334a, 334b, 334c, and 334d may be disposed at vertex portions of the peripheries (e.g., the periphery areas 212a-1 to 212a-3 and/or 212b-1 to 212b-3 of FIG. 2A and/or FIG. 2B) of the electronic device 301. The outer cover 330 may include a cover hole 335. The cover hole 335 may be disposed in an area corresponding to an area in the outer cover 330 where an input module (e.g., the input module 250 of FIG. 2A or 2B) of the electronic device 301 is disposed.

In an embodiment, the frame module 320 may include the bracket 340 (e.g., the plate structure 242 of FIG. 2C). The bracket 340 may include the bracket end surface 340a formed to surround the outer portion of the bracket 340. The bracket end surface 340a of the bracket 340 may be disposed to face the second cover surface 330b of the outer cover 330. The bracket end surface 340a may be disposed to come into contact with at least a portion of the second cover surface 330b. The bracket 340 may include bracket corners 344a, 344b, 344c, and 344d. The bracket corners 344a, 344b, 344c, and 344d may correspond to areas where the cover corners 334a, 334b, 334c, and 334d are disposed.

In an embodiment, the outer cover 330 and the bracket 340 may be coupled in a hook manner. In an embodiment, the outer cover 330 and the bracket 340 may be coupled by a bonding method using an adhesive material. In an embodiment, the outer cover 330 and the bracket 340 may be coupled in a tight-fitting manner.

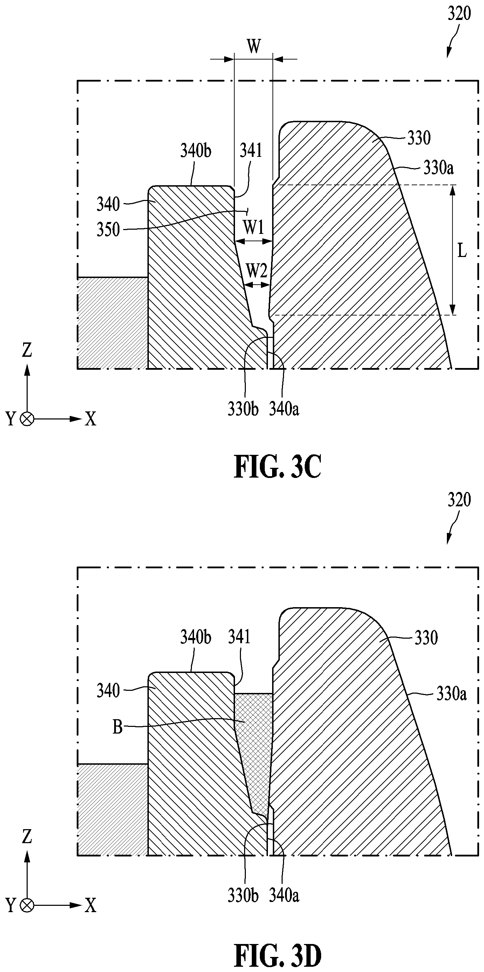

In an embodiment, the frame module 320 may include a buffer groove 350. The buffer groove 350 may be a space formed by a partial surface of the bracket end surface 340a that is not in contact with the second cover surface 330b. The buffer groove 350 may be filled with a buffer member (e.g., a buffer member B of FIG. 3D). The buffer member B may filled with a volume of 60% to 90%, preferably 70% to 80% with respect to a total volume of the buffer groove 350. In an embodiment, the buffer groove 350 may be filled with the buffer member B, thereby increasing durability of an area including the buffer groove 350. The buffer groove 350 may be disposed on at least one of edges of the electronic device 301 corresponding to the cover corners 334a, 334b, 334c, and 334d and/or the bracket corners 344a, 344b, 344c, and 344d (e.g., edge potions (e.g., the periphery areas 212a-1 to 212a-3 and/or 212b-1 to 212b-3 of FIG. 2A and/or FIG. 2B) of the electronic device 301 (e.g., the electronic device 201 of FIGS. 2A to 2C). The buffer groove 350 may be disposed in an area corresponding to the cover hole 335.

Continuing to refer to FIGS. 3A and 3B, the outer cover 330 may extend to the display 311a and/or the rear cover 311b, and for example, the outer cover 330 may extend from the edge of the display 311a to the edge of the rear cover 311b. The outer cover 330 extending from the edge of the display 311a to the edge of the rear cover 311b may firmly protect mechanical/electronic components accommodated in the electronic device 301.

FIGS. 3C and 3D are enlarged views of a region A of the frame module 320 of FIG. 3B according to various embodiments.

Referring to FIGS. 3C and 3D, the second cover surface 330b of the outer cover 330 and the bracket end surface 340a of the bracket 340 may include areas that come into contact with each other and/or that are disposed adjacent to each other. The second cover surface 330b of the outer cover 330 and the bracket end surface 340a of the bracket 340 may be spaced apart from each other to have an area for forming a space therebetween. In the area where the second cover surface 330b and the bracket end surface 340a are spaced apart from each other, the second cover surface 330b and the bracket end surface 340a may be formed to be inclined. The second cover surface 330b and the bracket end surface 340a may be formed to be inclined in directions facing each other. The buffer groove 350, that is a space formed by the second cover surface 330b and the bracket end surface 340a, may have a width that reduces in a direction (e.g., the -Z direction) from a bracket peak surface 340b toward the bracket end surface 340a. A width of the buffer groove 350 may be set as a distance between the bracket end surface 340a and the second cover surface 330b, and a maximum width W of the buffer groove 350 may be formed at a position corresponding to an area closest to the bracket peak surface 340b based on the bracket end surface 340a. The maximum width W of the buffer groove 350 may be formed at a position corresponding to an area separated from the bracket peak surface 340b by a predetermined distance or more based on the bracket end surface 340a. For example, the buffer groove 350 may be formed to be tapered from the display 311a toward the rear cover 311b. The maximum width W of the buffer groove 350 may be greater than 0.3 millimeters (mm). In order for the buffer member B to be uniformly applied to the buffer groove 350 without being affected by a surface tension and/or assembly tolerance of the buffer member B, the maximum width W of the buffer groove 350 may be greater than 0.3 mm. In an embodiment, the maximum width W of the buffer groove 350 may be greater than 0.35 mm. In an embodiment, the maximum width W of the buffer groove 350 may be greater than 0.4 mm. In an embodiment, the maximum width W of the buffer groove 350 may be less than 0.3 mm depending on the type of the buffer member B.

Particularly, referring to FIG. 3C, the buffer groove 350 may have a depth L in a direction from the display 311a to the rear cover 311b. In an embodiment, the depth L of the buffer groove 350 may be larger than the maximum width W of the buffer groove 350. When the buffer groove 350 has a first width W1 and a second width W2 that is a width of a portion positioned closer to the rear cover 311b than the first width W1, the first width W1 may be larger than or equal to the second width W2.

In an embodiment, the buffer member B may be one or a combination of materials having adhesiveness and shock absorption. In an embodiment, the buffer member B may be an acrylic material. For example, the buffer member B may include polyurethane reactive. For example, the buffer member B may include a resin. For example, the buffer member B may include epoxy. The buffer member B may include an ultraviolet (UV) coating agent. For example, the buffer member B may be a combination of the materials described above.

In an embodiment, the buffer member B may be filled by a jetting method. When the buffer member B is filled by the jetting method, the buffer member B may be filled even in a bottom portion of the buffer groove 350.

In an embodiment, the buffer member B may be filled by a contact bonding method. When the buffer member B is filled by the contact bonding method, the buffer member B may be filled in a target area of the buffer groove 350.

In an embodiment, the bracket 340 may include a bracket recess 341. The bracket recess 341 may be formed to be recessed in a direction (e.g., the -X direction) opposite to a direction (e.g., the +X direction) from the bracket end surface 340a toward the second cover surface 330b. The buffer member B may be filled in a space formed between the bracket recess 341 and the second cover surface 330b.

In an embodiment, the buffer member B may be filled after the assembly of the bracket 340 and the outer cover 330, and the buffer member B may be covered with the display 311a not to be exposed to the outside of the electronic device 301.

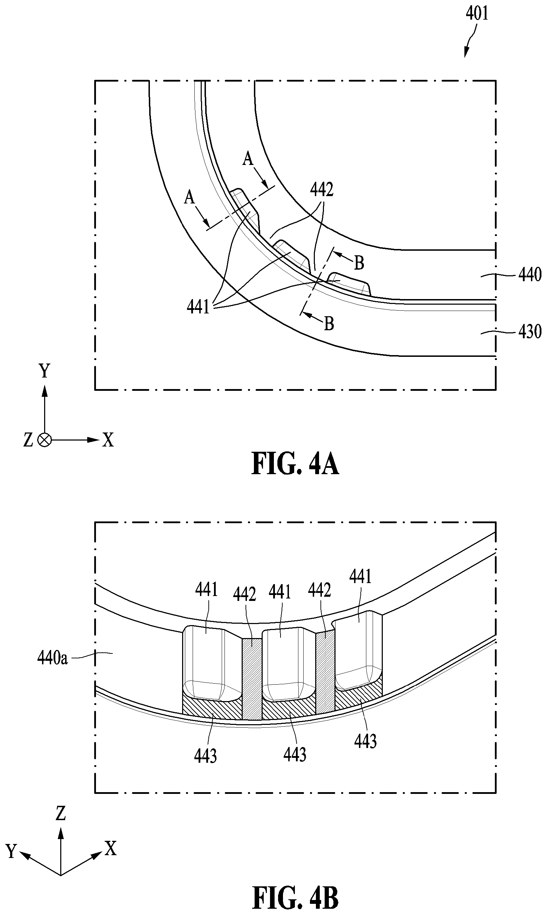

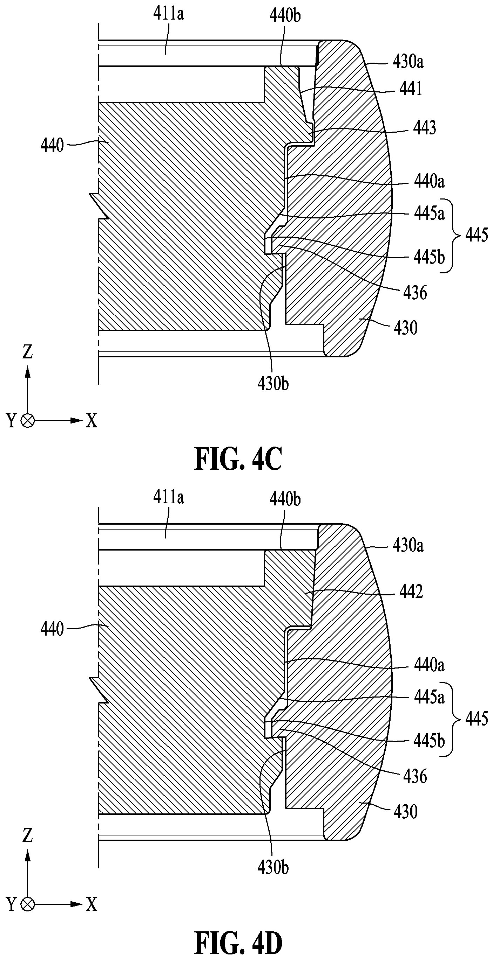

FIG. 4A is an enlarged view of a portion of an electronic device 401 (e.g., the electronic device 301 of FIG. 3A) according to various embodiments. FIG. 4B is partial perspective view illustrating a front view of a frame module 420 (e.g., the frame module 320 of FIG. 3B and/or FIG. 3C) according to various embodiments. FIG. 4C is a partial cross-sectional view of the frame module 420 of FIG. 4A taken along a line A-A according to various embodiments. FIG. 4D is a partial cross-sectional view of the frame module 420 of FIG. 4A taken along a line B-B according to various embodiments.

In an embodiment, the electronic device 401, the frame module 420, or a combination thereof may be coupled to at least one configuration or feature of the above-described embodiments, unless it is technically impossible.

Referring to FIGS. 4A, 4B, 4C and 4D (which may be referred to as FIGS. 4A to 4D), a bracket 440 (e.g., the bracket 340 of FIGS. 3A to 3D) may include a plurality of bracket recesses 441 (e.g., the bracket recess 341 of FIGS. 3B to 3D). The bracket 440 may include at least one bracket rib 442. The bracket rib 442 may be formed between the plurality of bracket recesses 441. The bracket rib 442 may be disposed closer to the second cover surface 430b (e.g., the second cover surface 330b of FIGS. 3A to 3D) of the outer cover 430, compared to the bracket recess 441. At least a portion of the bracket rib 442 may be disposed in contact with the second cover surface 430b of the outer cover 430 (e.g., the outer cover 330 of FIGS. 3A to 3D). The bracket recesses 441 and the bracket ribs 442, that are continuously disposed, may be coupled to the outer cover 430 to form a plurality of buffer grooves (e.g., the buffer groove 350 of FIG. 3C).

In an embodiment, since the bracket recesses 441 and the bracket ribs 442 are alternately and continuously disposed, a contact area of the buffer groove (e.g., the buffer groove 350 of FIG. 3C) and the buffer member B may increase. Since the bracket recesses 441 and the bracket ribs 442 are alternately and continuously disposed, inclination of the buffer member B filled in a space between the bracket recess 441 and the second cover surface 430b may be reduced. Since the bracket recesses 441 and the bracket ribs 442 are alternately and continuously disposed, a contact area of the bracket 440 and the buffer member B may increase. Since the bracket recesses 441 and the bracket ribs 442 are alternately and continuously disposed, damage on the electronic device 401 may be reduced when there is a shock greater than the shock that the buffer member B is able to withstand.

In an embodiment, the bracket 440 may include a plurality of bracket jaws 443. The bracket jaw 443 may start at a point where the bracket recess 441 of the bracket end surface 440a ends. The bracket jaw 443 may end at any point on the bracket end surface 440a. The bracket jaw 443 may be disposed more adjacent to the second cover surface 430b of the outer cover 430, compared to the bracket recess 441. At least a portion of the bracket jaw 443 may be disposed in contact with the second cover surface 430b of the outer cover 430. The bracket jaw 443 may prevent and/or reduce the buffer member B filled in the buffer groove (e.g., the buffer groove 350 of FIG. 3C) from leaking from the buffer groove 350.

Referring to FIG. 4C, the bracket recess 441 may have an inclined structure. The bracket recess 441 may have a width that narrows as it moves from the bracket peak surface 440b (e.g., the bracket peak surface 340b of FIGS. 3B to 3D) in a first direction (e.g., the -Z direction). With such a structure, the buffer member B filled in the buffer groove 350 may be easily settled in a space (e.g., the buffer groove 350 of FIG. 3B or 3C) between the bracket recess 441 and the second cover surface 430b.

Referring to FIG. 4D, in an embodiment, the bracket rib 442 may be disposed adjacent to the second cover surface 430b of the outer cover 430. In an embodiment, the bracket rib 442 may be disposed in close contact with the second cover surface 430b of the outer cover 430. Since the bracket rib 442 is disposed in close contact with the second cover surface 430b, leakage of the buffer member B filled in the buffer groove 350 may be reduced.

Referring to FIGS. 4C and 4D, in an embodiment, the outer cover 430 may include a cover hook 436. In an embodiment, the bracket 440 may include a bracket groove 445. In an embodiment, the bracket groove 445 may include a first groove surface 445a and a second groove surface 445b. The first groove surface 445a according to an embodiment may be formed obliquely with respect to the bracket end surface 440a. The second groove surface 445b according to an embodiment may be formed parallel to the bracket end surface 440a. In an embodiment, the cover hook 436 and the bracket groove 445 may correspond to each other. In an embodiment, since the cover hook 436 and the bracket groove 445 may be coupled to each other, the movement of the outer cover 430 in a direction (e.g., the +Z direction or the -Z direction) perpendicular to the display 311a and/or the rear cover 311b may be reduced.

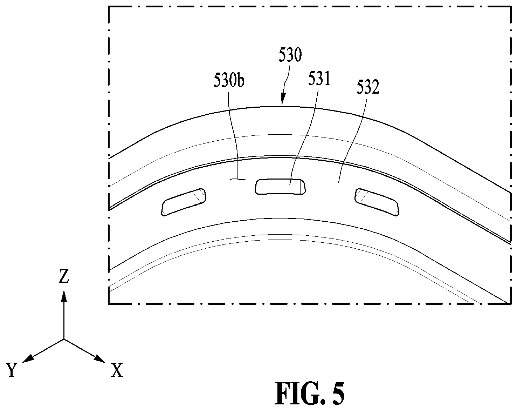

FIG. 5 is a partial perspective view of an outer cover 530 (e.g., the outer cover 330 of FIG. 3A and/or the outer cover 430 of FIGS. 4A to 4D) according to various embodiments.

In an embodiment, the outer cover 530 may be combined with at least one configuration or feature of the above-described embodiments, unless it is technically impossible.

In an embodiment, the outer cover 530 may include a cover recess 531. The cover recess 531 may be formed to be recessed in a direction (e.g., the -X direction or -Y direction) opposite to a direction (e.g., the +X direction or +Y direction) from a second cover surface 530b toward the bracket end surface (e.g., the bracket end surface 340a of FIGS. 3A to 3C). In an embodiment, the cover recess 531 may be disposed on the second cover surface 530b of the outer cover 530 corresponding to the bracket recess (e.g., the bracket recess 441 of FIGS. 4A to 4C) of the bracket (e.g., the bracket 440 of FIGS. 4A to 4D).

In an embodiment, the outer cover 530 may include a plurality of cover recesses 531. The outer cover 530 may include at least one cover rib 532. The cover rib 532 may be formed between the plurality of cover recesses 531. The cover rib 532 may be disposed more adjacent to a bracket end surface (e.g., the bracket end surface 440a of FIGS. 4A to 4D) of a bracket (e.g., the bracket 440 of FIGS. 4A to 4D), compared to the cover recess 531. At least a portion of the cover rib 532 may be disposed in contact with the bracket end surface 440a of the bracket 440. The cover recesses 531 and the cover ribs 532, that are continuously disposed, may be coupled to the bracket 440 to form a plurality of buffer grooves (e.g., the buffer groove 350 of FIG. 3C).

In an embodiment, a space (e.g., the buffer groove (e.g., the buffer groove 350 of FIG. 3B)) formed between the cover recess 531 and a bracket end surface (e.g., the bracket end surface 340a of FIGS. 3A to 3C) may be filled with the buffer member B.

In an embodiment, the buffer member B may be filled in a space (e.g., a buffer groove (e.g., the buffer groove 350 of FIG. 3B)) formed between the cover recess 531 and a bracket recess (e.g., the bracket recess 441 of FIGS. 4A to 4C). For example, the buffer groove 350 may be formed in a space between the bracket recess 341, 441, or 641 and the cover recess 531.

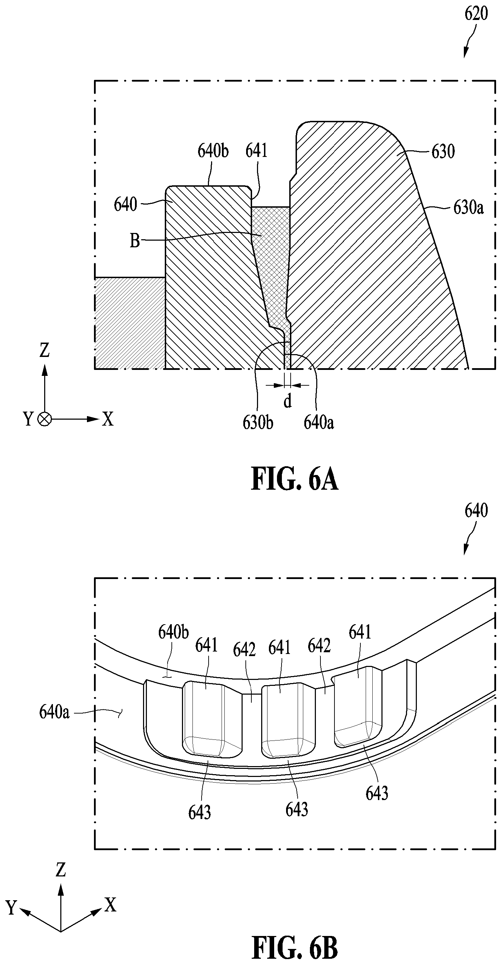

FIG. 6A is a partial cross-sectional view of a frame module 620 (e.g., the frame module 320 of FIG. 3A, FIG. 3C, and/or FIG. 3D) according to various embodiments. FIG. 6B is a partial perspective view of a bracket 640 (e.g., the bracket 340 of FIGS. 3A to 3C and/or the bracket 440 of FIGS. 4A to 4D) according to various embodiments.

In an embodiment, the frame module 620, the bracket 640, or a combination thereof may be combined with at least one configuration or feature of the above-described embodiments, unless it is technically impossible.

Referring to FIGS. 6A and 6B, in an embodiment, the frame module 620 may include an outer cover 630. The outer cover 630 may include a first cover surface 630a, and a second cover surface 630b (e.g., an inner surface of the outer cover) formed on a side opposite to the first cover surface 630a.

In an embodiment, the frame module 620 may include the bracket 640. The bracket 640 may include a bracket end surface 640a (e.g., an outer surface of the bracket) and a bracket upper surface 640b (e.g., an upper surface of the bracket). The bracket 640 may include a bracket recess 641 (e.g., the bracket recess 341 of FIGS. 3B to 3D and/or the bracket recess 441 of FIGS. 4A to 4D). The bracket 640 may include a bracket rib 642 (e.g., the bracket rib 442 of FIGS. 4A to 4D).

In an embodiment, the second cover surface 630b and the bracket end surface 640a may be disposed to face each other. In an embodiment, a spacing may be formed between the second cover surface 630b and the bracket end surface 640a. A width d of the spacing may be less than or equal to the maximum width W of the buffer groove (e.g., the buffer groove 350 of FIG. 3B or 3C). In an embodiment, the spacing formed between the second cover surface 630b and the bracket end surface 640a may make the buffer member B to be filled in a large area of the frame module 620. Continuing to refer to FIGS. 6A and 6B, the buffer member B may be disposed to extend to a region outside the buffer groove 350, as well as the buffer groove 350. In an embodiment, the width d of the spacing may vary according to the type of buffer member B. The width d of the spacing may vary according to a thixotropic property among physical properties of the buffer member B. As the thixotropy of the buffer member B is high, the viscosity may be high, which makes the width d of the spacing wide. As the thixotropy of the buffer member B is low, the viscosity may be low, which makes the width d of the spacing narrow. However, the buffer member B may be applied to a wider area of the frame module 620.

An embodiment of the disclosure may provide frame modules 320 and 620 having the shock-absorbing effect and the electronic devices 301 and 401 including the same.

According to an example embodiment, an electronic device may include: a display positioned on a first side of the electronic device. The electronic device may include a rear cover positioned on a second side of the electronic device opposite to the first side. The electronic device may include a bracket disposed between the display and the rear cover to support at least a portion of the display. The bracket may include a bracket end surface. The electronic device may include an outer cover covering the bracket. The outer cover may include a first cover surface. The outer cover may include a second cover surface opposite to the first cover surface. The electronic device may include a buffer member filling a buffer groove. The buffer groove may be formed between the bracket end surface of the bracket and at least a portion of the second cover surface of the outer cover, wherein the bracket end surface and the portion of the second cover surface face each other. A buffer member may be filled in the buffer groove. The buffer member may comprise a buffer material. According to the above-described example embodiment, damage on the electronic device 301 or 401 may be reduced when it is dropped. According to the above-described example embodiment, overall durability of the electronic device 301 or 401 may increase. According to the above-described example embodiment, there may be various effects including the above-described effects.

In an example embodiment, the bracket end surface and the second cover surface are inclined in directions facing each other and configured to settle the buffer member in the buffer groove. According to the above-described example embodiment, the buffer groove may be fully filled with the buffer member. According to the above-described example embodiment, there may be various effects including the above-described effect.

In an example embodiment, the bracket may include at least one bracket recess. The bracket recess may be formed in a direction opposite to a direction from the bracket end surface toward the second cover surface.

In an example embodiment, the bracket recess may be plural. The bracket may further include at least one bracket rib formed between the bracket recesses. At least a portion of the bracket rib may be in contact with the second cover surface. According to the above-described example embodiment, the buffer member may be filled on the frame module without changing the dimensions of the electronic device. According to the above-described example embodiment, there may be various effects including the above-described effect.

In an example embodiment, the bracket may further include a bracket jaw. The bracket jaw may be formed at a point where the bracket recesses end. At least a portion of the bracket jaw may be in contact with the second cover surface. According to the above-described example embodiment, the leakage of the buffer member may be reduced. According to the above-described example embodiment, there may be various effects including the above-described effect.

In an example embodiment, the buffer member disposed in a space formed between the bracket recess and the second cover surface. According to the above-described example embodiment, the buffer member may be disposed on the frame module without changing the dimensions of the electronic device. According to the above-described example embodiment, there may be various effects including the above-described effect.

In an example embodiment, the outer cover may include at least one cover recess. The cover recess may be formed in a direction opposite to a direction from the second cover surface toward the bracket end surface.

In an example embodiment, the cover recess may be plural. The outer cover may further include at least one cover rib formed between the cover recesses. At least a portion of the cover rib may be in contact with the bracket end surface. The buffer member may be disposed in a space formed between the cover recess and the bracket end surface. According to the above-described example embodiment, the buffer member may be disposed on the frame module without changing the dimensions of the electronic device. According to the above-described example embodiment, there may be various effects including the above effect.

In an example embodiment, a maximum width of the buffer groove may be greater than 0.3 mm. According to the above-described example embodiment, based on the buffer member being liquid, the buffer member may be disposed regardless of a surface tension between the buffer members and/or an assembly tolerance of the frame module or 620. According to the above-described example embodiment, there may be various effects including the above-described effect.

In an example embodiment, a spacing may be formed between the bracket end surface and the second cover surface. According to the above-described example embodiment, the buffer member may provided in a wider area of the frame module. According to the above-described example embodiment, there may be various effects including the above-described effect.

In an example embodiment, the buffer member may be jet filled. According to the above-described example embodiment, the buffer groove may be fully filled with the buffer member. According to the above-described example embodiment, there may be various effects including the above-described effect.

In an example embodiment, a depth of the buffer groove set in a direction from the display toward the rear cover may be larger than or equal to a maximum width of the buffer groove.

In an example embodiment, the buffer member may include at least one or a combination of polyurethane, epoxy, or a UV coating agent.

In an example embodiment, the bracket and the outer cover may be coupled by the buffer member. According to the above-described example embodiment, the buffer member may be disposed on the frame module without changing the dimensions of the electronic device. According to the above-described example embodiment, there may be various effects including the above-described effect.

In an example embodiment, the buffer groove may be disposed on at least one of a plurality of edges of the electronic device.

In an example embodiment, the outer cover may extend from an edge of the display to an edge of the rear cover. According to the above-described example embodiment, the side surface of the electronic device may be integrally formed, thereby reducing the inflow of foreign materials. According to the above-described example embodiment, there may be various effects including the above-described effect.

According to an example embodiment, a frame module may include a bracket. The bracket may include a bracket having a bracket end surface. The frame module may include an outer cover enclosing the bracket. The outer cover may include a first cover surface. The outer cover may include a second cover surface opposite to the first cover surface. The frame module may include a buffer member. The buffer groove may be formed between the bracket end surface of the bracket and at least a portion of the second cover surface of the outer cover which face each other. The buffer member including a buffer material may be disposed in the buffer groove and is configured to provide a shock-absorbing effect. The bracket and the outer cover may be coupled by the buffer member. The buffer member may include a buffer material. According to the above-described example embodiment, damage on the electronic device may be reduced when it is dropped. According to the above-described example embodiment, overall durability of the electronic device may increase. According to the above-described example embodiment, there may be various effects including the above-described effects.

In an example embodiment, the bracket end surface, the second cover surface, or a combination thereof may be inclined in directions facing each other and configured to settle the buffer member in the buffer groove. According to the above-described example embodiment, the buffer groove may be fully filled with the buffer member. According to the above-described example embodiment, there may be various effects including the above-described effect.

In an example embodiment, the bracket may include at least one bracket recess. The bracket recess may be formed in a direction opposite to a direction from the bracket end surface toward the second cover surface.

In an example embodiment, the bracket recess may be plural. The bracket may include at least one bracket rib formed between the bracket recesses. The bracket may include at least one bracket jaw. The bracket jaw may be formed at a point where the bracket recesses end. The bracket rib and at least a portion of the bracket jaw may be in contact with the second cover surface. According to the above-described example embodiment, the buffer member may be disposed on the frame module without changing the dimensions of the electronic device. According to the above-described example embodiment, there may be various effects including the above-described effect.

According to an example embodiment, an electronic device may include: a display positioned on a first side of the electronic device. The electronic device may include a rear cover positioned on a second side opposite to the first side. The electronic device may include a bracket disposed between the display and the rear cover to support at least a portion of the display. The bracket may include a bracket end surface. The electronic device may include an outer cover enclosing the bracket. The outer cover may include a first cover surface. The outer cover may include a second cover surface opposite to the first cover surface. The electronic device may include a buffer member. A buffer groove may have a space between the bracket end surface of the bracket and at least a portion of the second cover surface of the outer cover which face each other. The bracket may include a plurality of bracket recesses formed in a direction opposite to a direction from the bracket end surface toward the second cover surface. The bracket may include at least one bracket rib formed between the bracket recesses. The bracket may include at least one bracket jaw formed at a point where the bracket recesses end. The outer cover may include a plurality of cover recesses. The plurality of cover recesses may be formed in a direction opposite to a direction from the second cover surface toward the bracket end surface. The buffer groove may be formed in a space between the bracket recess and the cover recess. According to the above-described example embodiment, damage to the electronic device may be reduced when it is dropped. According to the above-described example embodiment, overall durability of the electronic device may increase. According to the above-described example embodiment, there may be various effects including the above-described effects.

The embodiments of the present disclosure are intended to be illustrative and not restrictive. Various modifications may be made to the various example embodiments of the present disclosure within the spirit and scope of the disclosure, including the appended claims and their equivalents. Any of the embodiment(s) described herein may be used in combination with any other embodiment(s) described herein.

While various example embodiments are described with reference to drawings, it will be apparent to one of ordinary skill in the art that various alterations and modifications in form and details may be made in these example embodiments without departing from the spirit and scope of the claims and their equivalents. For example, suitable results may be achieved if the described techniques are performed in a different order and/or if components in a described system, architecture, device, or circuit are combined in a different manner and/or replaced or supplemented by other components or their equivalents.

Therefore, other implementations, other embodiments, and/or equivalents of the claims are within the scope of the following claims.

## Claims

1. An electronic device comprising:
a display (311a) positioned on a first side of the electronic device;
a rear cover (311b) positioned on a second side of the electronic device opposite to the first side;
a bracket (340; 440; 640) disposed between the display (311a) and the rear cover (311b) to support at least a portion of the display (311a) and having a bracket end surface (340a; 440a; 640a);
an outer cover (330; 430; 530; 630) having a first cover surface (330a; 430a) and a second cover surface (330b; 430b; 530b) opposite to the first cover surface (330a; 430a), and covering the bracket (340; 440; 640); and
a buffer member (B) filling buffer groove (350) formed between the bracket end surface (340a; 440a; 640a) of the bracket (340; 440; 640) and at least a portion of the second cover surface (330b; 430b; 530b) of the outer cover (330; 430; 530; 630) which face each other,
wherein the buffer member (B) comprises a buffer material.

2. The electronic device of claim 1, wherein the bracket end surface (340a; 440a; 640a) and the second cover surface (330b; 430b; 530b) are inclined in directions facing each other and configured to settle the buffer member (B) in the buffer groove (350).

3. The electronic device of claims 1 or 2, wherein the bracket (340; 440; 640) comprises at least one bracket recess (341; 441; 641) formed in a direction opposite to a direction from the bracket end surface (340a; 440a; 640a) toward the second cover surface (330b; 430b; 530b).

4. The electronic device of claim 3,
including a plurality of bracket recesses (341; 441; 641),
wherein the bracket (340; 440; 640) further comprises at least one bracket rib (442; 642) formed between the bracket recesses (341; 441; 641), and
wherein at least a portion of the bracket rib (442; 642) is in contact with the second cover surface (330b; 430b; 530b).

5. The electronic device of claim 3,
wherein the bracket (340; 440; 640) further comprises at least one bracket jaw (443; 643) formed at a point where the bracket recesses (341; 441; 641) end, and
wherein at least a portion of the bracket jaw (443; 643) is in contact with the second cover surface (330b; 430b; 530b).

6. The electronic device of claim 3, wherein the buffer member (B) is filled in a space formed between the bracket recess (341; 441; 641) and the second cover surface (330b; 430b; 530b).

7. The electronic device according to one of claims 1 to 6, wherein the outer cover (330; 430; 530; 630) comprises at least one cover recess (531) formed in a direction opposite to a direction from the second cover surface (330b; 430b; 530b) toward the bracket end surface (340a; 440a; 640a).

8. The electronic device of claim 7,
including a plurality of cover recesses (531),
wherein the outer cover (530) further comprises at least one cover rib (532) formed between the cover recesses (531),
wherein at least a portion of the cover rib (532) is in contact with the bracket end surface (340a; 440a; 640a), and
wherein the buffer member (B) is filled in a space between the cover recess (531) and the bracket end surface (340a; 440a; 640a).

9. The electronic device according to one of claims 1 to 8, wherein a maximum width of the buffer groove (350) is greater than 0.3 millimeters.

10. The electronic device according to one of claims 1 to 9, wherein a spacing is formed between the bracket end surface (340a; 440a; 640a) and the second cover surface (330b; 430b; 530b).

11. The electronic device according to one of claims 1 to 10, wherein a depth (L) of the buffer groove (350) set in a direction from the display (311a) toward the rear cover (311b) is larger than a maximum width (W) of the buffer groove (350).

12. The electronic device according to one of claims 1 to 11, wherein the buffer member (B) comprises at least one or a combination of polyurethane, epoxy, or an ultraviolet (UV) coating agent.

13. The electronic device according to one of claims 1 to 12, wherein the bracket (340; 440; 640) and the outer cover (330; 430; 530; 630) are coupled by the buffer member (B) and the buffer member (B) is filled by jetting.

14. The electronic device according to one of claims 1 to 13, wherein the buffer groove (350) is disposed on at least one of a plurality of edges of the electronic device (301; 401).

15. The electronic device according to one of claims 1 to 14, wherein the outer cover (330; 430; 530; 630) extends from an edge of the display (311a) to an edge of the rear cover (311b).
